# FASCICULE DE BREVET EUROPEEN

(11) **EP 3 401 657 B1**
(45) Date de publication et mention de la délivrance du brevet: **03.04.2024**
(21) Numéro de dépôt: 18170940.3
(22) Date de dépôt: 04.05.2018
(51) Int. Cl.: G01J 5/02, G01J 5/20, H01L 31/18

(54) **PROCEDE DE REALISATION D'UN DETECTEUR BOLOMETRIQUE**
VERFAHREN ZUR HERSTELLUNG EINES BOLOMETRISCHEN DETEKTORS
METHOD FOR MANUFACTURING A BOLOMETRIC DETECTOR

(30) Priorité: 09.05.2017 FR 1754060
(43) Date de publication de la demande: 14.11.2018
(73) Titulaire: Commissariat à l'énergie atomique et aux énergies alternatives, 75015 Paris (FR)
(72) Inventeur: LEDUC, Patrick, 38000 GRENOBLE (FR); CORTIAL, Sébastien, 38360 SASSENAGE (FR); POCAS, Stéphane, 38000 GRENOBLE (FR); YON, Jean-Jacques, 38360 SASSENAGE (FR)
(74) Mandataire: Brevalex

(56) Documents cités:
- EP-A1- 2 743 659
- DE-A1- 10 058 864

## Description

### DOMAINE TECHNIQUE ET ART ANTÉRIEUR

L'invention concerne le domaine des détecteurs de rayonnement électromagnétique à bolomètres ou micro-bolomètres, destinés à la détection de rayonnements dans le domaine « thermique » ou infrarouge.

Dans ce document, le terme « bolomètre » est utilisé de manière générique quelles que soient les dimensions du bolomètre, et désigne donc un bolomètre ou un micro-bolomètre de dimensions micrométriques.

Un détecteur à bolomètres, ou détecteur bolométrique, comporte généralement un ensemble de bolomètres disposés en surface d'un substrat support en formant une matrice. Chacun des bolomètres est destiné à fournir une information thermique relative à un pixel d'une image fournie par le détecteur.

Chaque bolomètre comporte une membrane suspendue reliée mécaniquement et électriquement au substrat au moyen de longues poutres étroites appelées bras de maintien et reliées à des piliers électriquement conducteurs assurant la suspension de la membrane. L'ensemble est placé dans une enceinte hermétique, par exemple un boitier sous pression très réduite, de manière à supprimer la conductance thermique du gaz environnant.

Lors du fonctionnement du détecteur, la membrane de chaque bolomètre s'échauffe en absorbant le rayonnement incident en provenance de la scène thermique observée, ce rayonnement étant transmis et focalisé sur la matrice de bolomètres par une optique adéquate au niveau du plan focal matriciel. Cette membrane comporte un dispositif de transduction thermique-électrique dont une caractéristique électrique (par exemple la résistivité) évolue sensiblement lorsque la température change, générant par exemple une variation de courant, c'est-à-dire un signal électrique, lorsque ce matériau est sous une polarisation constante, dont l'amplitude est fonction du flux du rayonnement incident. Le signal obtenu correspond à l'image de la température du détecteur. Un tel dispositif de transduction thermique-électrique correspond par exemple à une couche de matériau transducteur, par exemple un oxyde métallique (VOx, NiOx, TiOx) ou du silicium amorphe (a-Si), ou à une diode ou un transistor.

Les procédés de fabrication classiques de tels détecteurs, de type « above IC »ou « MEMS on top », comprennent des étapes mises en oeuvre directement depuis la surface d'un substrat généralement en silicium et comportant une pluralité de circuits électroniques formant le circuit de lecture ou ROIC (« Read Out Integrated Circuit »), de manière dite monolithique. Ce terme « monolithique » désigne une séquence continue d'opérations mises en oeuvre depuis le même substrat, à la suite du processus de fabrication du circuit de lecture.

Les étapes de fabrication des bolomètres sont en général mises en oeuvre pour réaliser collectivement plusieurs détecteurs, par exemple entre quelques dizaines et quelques centaines sur un même substrat.

Au cours de ces étapes, les éléments des bolomètres remplissant les fonctions d'absorption de rayonnement, de transduction optique-thermique et de transduction thermique-électrique sont mis en place à la surface d'une couche sacrificielle destinée à former une base de construction et à être éliminée en fin de processus par un procédé adéquat qui n'agresse pas les autres éléments (les organes structuraux et actifs) de la structure. La couche sacrificielle correspond généralement à une couche organique de polyimide qui est ensuite éliminée par combustion dans un plasma oxygéné

Les couches diélectriques ou semi-conductrices qui forment les éléments de la structure de détection sont réalisées classiquement en oxyde de silicium (SiO), en nitrure de silicium (noté génériquement SiN), ou bien en silicium amorphe, comme décrit par exemple dans le document EP 0 828 145 A1. Ces matériaux peuvent être déposés à une température relativement basse et sont inertes vis-à-vis du procédé d'élimination de la couche sacrificielle organique mis en oeuvre sous plasma oxygéné, c'est-à-dire ne sont pas gravés par le plasma oxygéné.

Après la gravure de la couche sacrificielle, les membranes des bolomètres restent suspendues au-dessus du substrat sans autre contact ou attache que leurs bras de maintien.

Les bolomètres sont par exemple réalisés en formant une matrice avec un pas de répétition (distance séparant les centres de deux bolomètres voisins et disposés sur une même ligne ou une même colonne de la matrice) égal à 17 µm, voire même de l'ordre de 12 µm ou 10 µm.

Pour pouvoir réaliser une détection en infrarouge « lointain » (LWIR), le détecteur comporte généralement une lame, ou cavité, quart d'onde formée entre la membrane et un réflecteur disposé en surface du substrat, de manière à obtenir un maximum d'absorption du détecteur pour les longueurs d'onde au voisinage de 10 µm. Ainsi, afin de connecter et maintenir la membrane à une distance adaptée du réflecteur et avec un bon maintien mécanique, les piliers électriquement conducteurs réalisés sont plutôt complexes et d'encombrement non négligeable, et sont formés au travers d'une épaisse couche de polyimide (épaisseur généralement comprise entre 2 µm et 2,5 µm) formant la couche sacrificielle, l'épaisseur de cette couche sacrificielle de polyimide correspondant à la distance membrane - réflecteur souhaitée.

Dans le document EP 2 743 659 A1, il a été proposé d'intégrer les bolomètres en partie dans les couches « back-end » (ou « BEOL » pour « Back End Of Line ») du circuit de lecture des bolomètres. L'acronyme BEOL désigne les étapes de fabrication de l'ensemble des interconnexions métalliques mises en oeuvre à une température relativement basse, typiquement inférieure à environ 400°C, et qui sont caractéristiques de la fin des processus de fabrication microélectroniques standards. Le but de cette approche dite « MEMS-in-CMOS » est d'exploiter certaines dispositions du BEOL, matures sur le plan industriel, pour intégrer une partie des éléments des bolomètres. En particulier, des vias métallisés obtenus selon un procédé « damascene » sont réalisés pour former les piliers électriquement conducteurs des bolomètres, et une des IMD (« Inter-Metal-Dielectrics », ou diélectriques inter-métal), comprenant par exemple du SiO qui est un matériau standard en microélectronique, est utilisée comme couche sacrificielle sur laquelle les membranes des bolomètres sont réalisées.

L'élimination d'une telle couche sacrificielle nécessite l'utilisation d'acide fluorhydrique en phase vapeur (HFv). En conséquence, tous les matériaux constituant le bolomètre sont choisis parmi ceux qui sont inertes vis-à-vis de ce procédé chimiquement très agressif, c'est-à-dire parmi les matériaux non impactés par cette gravure.

En intégrant les bolomètres dans le BEOL, les derniers niveaux photolithographiques du ROIC normalement mis en oeuvre pour conduire un contact électrique en surface de la couche de passivation se trouvant au sommet du BEOL sont mis en oeuvre également pour la réalisation des piliers électriquement conducteurs des bolomètres. Il est donc économisé plusieurs niveaux lithographiques parmi l'ensemble des niveaux nécessaires à la fabrication des bolomètres, d'où une économie significative sur les coûts de fabrication de ces bolomètres. De plus, les piliers électriquement conducteurs de forme cylindrique ainsi réalisés bénéficient des règles de dessin de la filière CMOS, soit un diamètre égal à environ 0,5 µm, ce qui représente un gain de compacité très significatif par rapport aux piliers électriquement conducteurs généralement réalisés en technologie « above IC » qui occupent généralement une surface d'environ 3x3 µm². Ce gain d'espace peut constituer un avantage décisif dans un contexte de réduction du pas des détecteurs bolométriques matriciels.

Dans la structure décrite par le document EP 2 743 659 A1, la connexion électrique entre les piliers électriquement conducteurs et le métal présent dans la membrane du bolomètre pour assurer l'absorption du rayonnement électromagnétique peut être obtenue indirectement via une couche support de la membrane qui comporte du silicium amorphe. Cependant, la résistivité électrique de cette couche de silicium amorphe, non métallique, est très élevée par rapport à du métal et introduit, malgré sa faible épaisseur, une résistance électrique parasite en série avec l'élément transducteur thermique - électrique, ce qui pénalise la sensibilité des micro-détecteurs.

Pour surmonter cette limitation, le document EP 2 743 659 A1 décrit aussi un autre mode de réalisation dans lequel un contact électrique est prévu à travers la couche support de la membrane en silicium amorphe grâce à une ouverture formée à travers cette couche support, pour s'affranchir des inconvénients indiqués ci-dessus. Ce contact, et donc l'ouverture dans laquelle ce contact est réalisé, doit être inscrit dans la section transverse du pilier électriquement conducteur afin que la couche métallique présente dans la membrane du bolomètre puisse créer une continuité électrique fiable avec le métal qui constitue le pilier électriquement conducteur. Cette disposition fait apparaitre deux points critiques :
- la définition du contact par photolithographie et son alignement sur le pilier électriquement conducteur est très délicate voire impossible lorsque le diamètre du pilier électriquement conducteur est réduit à la dimension minimum autorisée par les moyens de photolithographie, ce qui constitue pourtant un des principaux intérêts de cette construction « MEMS in CMOS » du bolomètre. En effet, inscrire un contact à l'intérieur d'une section de diamètre égale à 0,5 µm nécessite l'utilisation de moyens de lithographies avancées non disponibles dans une ligne BEOL typique,
- le contact est réalisé à travers la couche de silicium amorphe dont l'épaisseur est généralement égale à 50 nm. La topographie engendrée ne doit pas créer de discontinuité de la couche de métal du bolomètre déposée dans le contact. Cette couche, qui est nécessairement très fine (typiquement 10 nm) puisqu'elle a aussi une fonction d'absorbeur de rayonnement dans la membrane bolométrique, sera peu efficace pour couvrir les flancs du contact gravé dans la couche support de silicium amorphe.

Par ailleurs, un autre inconvénient de cette solution est l'ajout d'un niveau de lithographie et gravure pour la réalisation de l'ouverture dans laquelle le contact doit être réalisé, ce qui représente un coût de fabrication supplémentaire.

Le document DE10058864A1 divulgue un procédé de réalisation d'un détecteur thermique de l'état de la technique.

### EXPOSÉ DE L'INVENTION

Un but de la présente invention est de proposer un procédé de réalisation d'un détecteur bolométrique dans lequel le ou les bolomètres sont réalisés en partie au sein du BEOL du circuit électronique de lecture du détecteur, et qui supprime les inconvénients décrits précédemment qui concernent le contact électrique entre la membrane d'un bolomètre et au moins un des piliers électriquement conducteurs auxquels la membrane de ce bolomètre est suspendue.

Pour cela, l'invention propose un procédé de réalisation d'un détecteur bolométrique comprenant au moins la mise en oeuvre des étapes suivantes :
- réalisation d'un empilement de couches sur un niveau d'interconnexion électrique d'un circuit électronique de lecture du détecteur, l'empilement comprenant au moins une couche sacrificielle disposée entre une couche support et une première couche d'arrêt de gravure, la première couche d'arrêt de gravure étant disposée entre la couche sacrificielle et ledit niveau d'interconnexion électrique, et la couche sacrificielle comprenant au moins un matériau minéral apte à être gravé sélectivement vis-à-vis de la couche support et de la première couche d'arrêt de gravure ;
- réalisation d'au moins un via électriquement conducteur traversant au moins l'empilement de couches tel qu'au moins un matériau électriquement conducteur du via soit en contact avec au moins une portion électriquement conductrice dudit niveau d'interconnexion électrique reliée au circuit électronique de lecture ;
- dépôt d'au moins une couche électriquement conductrice sur la couche support et le via ;
- gravure de la couche électriquement conductrice et de la couche support, formant une membrane de bolomètre reliée électriquement au via électriquement conducteur par au moins une portion restante de la couche électriquement conductrice qui recouvre au moins une partie supérieure du via ;
- suppression de la couche sacrificielle par une gravure chimique à laquelle la première couche d'arrêt de gravure et la couche support résistent, et telle que la membrane soit suspendue par l'intermédiaire du via.

Dans ce procédé, le ou les bolomètres sont réalisés sur un niveau d'interconnexion électrique du circuit électronique de lecture et en faisant appel à une couche sacrificielle minérale, et sont donc intégrés en partie au sein du BEOL de ce circuit.

De plus, du fait que la couche électriquement conductrice est déposée directement sur le via électriquement conducteur servant de pilier pour suspendre la membrane, et que le via électriquement conducteur est réalisé après avoir formé la couche support, le contact électrique entre la couche électriquement conductrice de la membrane et le via électriquement conducteur est réalisé directement entre ces deux éléments, sans présence de matériau semi-conducteur entre eux.

Ce procédé permet de former une connexion électrique directe entre le via électriquement conducteur et la couche électriquement conductrice de la membrane qui bénéficie d'un plus faible encombrement du fait qu'il n'est pas nécessaire de prévoir une grande surface de contact du pilier électriquement conducteur pour réaliser un alignement avec une ouverture qui serait formée à travers la couche support comme dans l'art antérieur. Le via électriquement conducteur peut donc être réalisé avec de plus petites dimensions que dans l'art antérieur, par exemple avec un diamètre ou un côté de dimension de l'ordre de 0,5 µm.

En outre, du fait que le contact électrique entre le via électriquement conducteur et la couche électriquement conductrice n'est pas formé dans une ouverture traversant la couche support, une faible épaisseur de la couche électriquement conductrice ne représente pas un inconvénient pour la fiabilité du contact.

Enfin, par rapport au procédé nécessitant la réalisation d'une ouverture à travers la couche support de la membrane pour réaliser le contact entre le pilier électriquement conducteur et la couche électriquement conductrice de la membrane, le procédé selon l'invention permet également de supprimer un niveau de photolithographie et de gravure en raison de l'absence de réalisation d'une telle ouverture dans ce procédé.

Le procédé selon l'invention permet d'obtenir une excellente continuité électrique entre le circuit de lecture et la membrane du bolomètre du fait que la liaison électrique entre le circuit de lecture et le matériau électriquement conducteur de la membrane est formée uniquement de matériaux électriquement conducteurs.

Les avantages ci-dessus sont obtenus quel que soit le matériau de la couche support.

L'empilement de couches comporte en outre une deuxième couche d'arrêt de gravure telle que la couche support soit disposée entre la deuxième couche d'arrêt de gravure et la couche sacrificielle, le procédé comportant en outre, entre la réalisation du via et le dépôt de la couche électriquement conductrice, la mise en oeuvre des étapes suivantes :
- retrait, par exemple par polissage mécano-chimique, d'une couche de matériau électriquement conducteur formée sur la deuxième couche d'arrêt de gravure lors de la réalisation du via, puis
- suppression de la deuxième couche d'arrêt de gravure,
et la couche électriquement conductrice est déposée telle que la portion restante de la couche électriquement conductrice recouvre également des flancs latéraux de la partie supérieure du via découverts (ou mis à nu ou révélés) par la suppression de la deuxième couche d'arrêt de gravure.

Du fait que la partie supérieure du via électriquement conducteur « dépasse » de la couche support, et donc que le maintien mécanique de la couche support par le via est réalisé sous cette partie supérieure, le maintien mécanique de la couche support, et donc de la membrane, au via électriquement conducteur est amélioré. De plus, du fait que la portion restante de la couche électriquement conductrice recouvre, en plus de la face supérieure du via, les flancs latéraux de cette partie supérieure du via, la surface de contact entre cette portion de la couche électriquement conductrice et le via électriquement conducteur augmente, et le contact électrique entre la couche électriquement conductrice et le via électriquement conducteur est donc amélioré.

La couche support peut comporter au moins un matériau diélectrique ou un matériau dont au moins un paramètre électrique varie en fonction de sa température. Ainsi, la couche support assure une fonction d'isolation électrique ou de transduction thermique - électrique au sein de la membrane du bolomètre.

Le procédé peut comporter en outre, avant la suppression de la couche sacrificielle, la réalisation d'au moins un élément absorbeur de rayonnement infrarouge destiné à être détecté par le détecteur, sur la membrane.

Dans ce cas, l'élément absorbeur peut comporter au moins une structure MIM (ou « Métal - Isolant - Métal »). D'autres types d'éléments absorbeurs peuvent être réalisés sur la membrane.

L'expression « structure MIM » désigne un empilement comportant au moins un élément diélectrique disposé entre un élément métallique supérieur et un élément métallique inférieur, et apte à réaliser une absorption sélective de certaines longueurs d'ondes selon les dimensions et les matériaux de la structure MIM.

La couche électriquement conductrice peut être gravée telle qu'une pluralité de portions restantes de ladite couche électriquement conductrice forment des électrodes de bolomètre et des portions résistives aptes à absorber un rayonnement infrarouge destiné à être détecté par le détecteur. Ces portions résistives peuvent être de n'importe quelle forme.

Le procédé peut comporter en outre, entre la gravure de la couche électriquement conductrice et la gravure de la couche support (la couche support étant gravée après la couche électriquement conductrice), le dépôt d'une première couche de transduction thermique-électrique sur les portions restantes de la couche électriquement conductrice et sur la couche support. Une telle première couche de transduction thermique-électrique peut être déposée sur la couche électriquement conductrice et sur la couche support. Outre la connexion électrique entre la couche conductrice et la couche de transduction thermique-électrique, cette disposition permet aussi de compenser un effet bilame se produisant entre les portions de la couche électriquement conductrice et la couche support.

La première couche de transduction thermique-électrique peut comporter au moins un matériau résistant à la gravure chimique mise en oeuvre pour supprimer la couche sacrificielle. Dans ce cas, cette première couche de transduction thermique-électrique peut également servir à protéger la couche électriquement conductrice vis-à-vis de la solution de gravure utilisée pour graver la couche sacrificielle.

Le procédé peut comporter en outre, après le dépôt de la première couche de transduction thermique-électrique, le dépôt d'une deuxième couche de transduction thermique-électrique sur la première couche de transduction thermique-électrique et dont l'épaisseur est supérieure à celle de la première couche de transduction thermique-électrique. Dans ce cas, le rapport signal à bruit de la conversion de l'énergie thermique absorbée en énergie électrique réalisée au sein du détecteur est améliorée. La deuxième couche de transduction thermique-électrique peut comporter au moins un matériau résistant à la gravure chimique mise en oeuvre pour supprimer la couche sacrificielle.

Cette deuxième couche de transduction thermique-électrique peut ensuite être gravée afin de former une ou plusieurs portions de matériau thermométrique sur la membrane, par exemple une portion centrale de matériau thermométrique.

Le procédé peut être tel que :
- la couche support comporte du silicium amorphe, et/ou
- lorsqu'une première couche de transduction thermique-électrique est déposée, la première couche de transduction thermique-électrique comporte du silicium amorphe, et/ou
- lorsqu'une deuxième couche de transduction thermique-électrique est déposée, la deuxième couche de transduction thermique-électrique comporte du silicium amorphe.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1N représentent des étapes d'un procédé de réalisation d'un détecteur bolométrique, objet de la présente invention, selon un premier mode de réalisation ;
- la figure 2 représente un détecteur bolométrique obtenu en mettant en oeuvre un procédé de réalisation, objet de la présente invention, selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités de réalisation (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

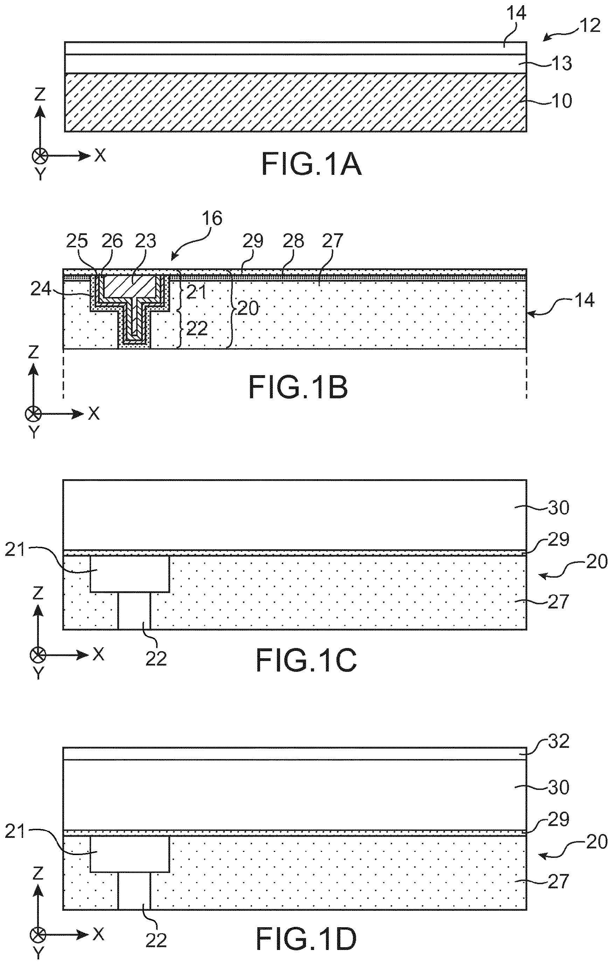

Un procédé de réalisation d'un détecteur bolométrique infrarouge 100 selon un premier mode de réalisation est décrit ci-dessous en lien avec les figures 1A à 1N.

Le dispositif 100 réalisé dans ce premier mode de réalisation comporte une pluralité de détecteurs thermiques, de type micro-bolomètre, qui sont réalisés à partir d'un substrat semi-conducteur 10, par exemple de silicium, sur et/ou dans lequel est intégré un circuit électronique de lecture 12 réalisé en technologie CMOS. Le circuit de lecture 12 assure la lecture de la variation de caractéristique électrique induite par l'échauffement de chacun des bolomètres, et également la polarisation des bolomètres.

Le circuit électronique de lecture 12 comporte des couches de semi-conducteur 13 (partie « Front End ») dans lesquelles sont réalisés des transistors, des diodes, des condensateurs et d'autres dispositifs électroniques de type MOS permettant la mise en oeuvre des fonctions électroniques du circuit de lecture 12. Un ou plusieurs niveaux d'interconnexion électrique 14 (partie « Back End ») reliant notamment des blocs fonctionnels du circuit de lecture 12 entre eux et destinés à former des liaisons d'entrée/sortie du circuit de lecteur 12, sont réalisés sur les couches de semi-conducteur 13 du circuit de lecture 12.

Le dernier niveau d'interconnexion électrique destiné à former les contacts électriques du circuit de lecture 12 n'est pas encore réalisé au stade représenté sur la figure 1A. Sur la figure 1A, la référence 14 peut donc désigner un seul niveau d'interconnexion électrique, correspondant à la fois au premier niveau d'interconnexion électrique et à l'avant-dernier niveau d'interconnexion électrique, ou bien plusieurs niveaux d'interconnexion électrique empilés allant du premier niveau d'interconnexion électrique (celui en contact avec les couches de semi-conducteur 13) jusqu'à l'avant-dernier niveau d'interconnexion électrique. Le dernier niveau d'interconnexion électrique va être réalisé tel qu'il intègre les bolomètres destinés à être réalisés de manière suspendue au-dessus du circuit de lecture 12 et assure les liaisons électriques entre les entrées du circuit de lecture 12 accessibles depuis les niveaux d'interconnexion électrique 14 et les connexions électriques de sortie des bolomètres. Ce dernier niveau d'interconnexion électrique est également réalisé afin de former des plots de connexion électrique du circuit de lecture 12 accessibles depuis l'extérieur, c'est-à-dire pouvant être contacté électriquement depuis l'extérieur du détecteur 100.

En variante, il est possible d'utiliser plusieurs (par exemple 2 ou 3) des derniers niveaux d'interconnexion électrique pour former les moyens de support mécanique des bolomètres et les moyens de liaison électrique entre les entrées du circuit de lecture 12 et les connexions électriques de sortie des bolomètres.

La figure 1B représente l'avant-dernier niveau d'interconnexion électrique 20 réalisé, faisant partie des niveaux d'interconnexions électriques 14 et sur lequel les bolomètres du détecteur 100 sont destinés à être réalisés. Ce niveau d'interconnexion électrique 20 comporte notamment une ligne métallique 21 dont des portions 16 (une seule portion 16 est représentée sur la figure 1B) sont reliées électriquement et localement, par l'intermédiaire de vias électriquement conducteurs 22, ou connexions verticales, et éventuellement par l'intermédiaire du ou des niveaux d'interconnexion électrique inférieurs, aux dispositifs électroniques MOS du circuit de lecture 12. Au moins une partie de ces portions 16 sont destinées à être reliées électriquement aux bolomètres du détecteur 100. En dehors des vias 22 qui assurent les liaisons électriques avec le niveau d'interconnexion électrique inférieur, le niveau d'interconnexion électrique 20 est isolé électriquement de la ligne métallique du niveau d'interconnexion électrique inférieur par une couche diélectrique 27, appelée diélectrique inter-métal (également appelé IMD, ou « Inter-Metal Dielectric »), qui est un matériau minéral et par exemple composé d'oxyde de silicium non dopé (également appelé USG, ou « Undoped Silica Glass ») ou d'un oxyde de plus faible permittivité diélectrique, tel que du SiOF, du SiOC, du SiOCH, etc.

Le niveau d'interconnexion électrique 20 peut également comporter d'autres portions (non représentées sur la figure 1B) de la ligne métallique 21, reliées ou non au niveau d'interconnexion électrique inférieur, destinées à ne pas être reliées aux bolomètres mais à servir par exemple à la réalisation, au moins en partie, de plots de connexion utilisés pour le test et le câblage filaire du circuit de lecture 12 et du détecteur 100 en général.

Différentes options techniques sont possibles pour réaliser les vias 22 et la ligne métallique 21 de l'avant-dernier niveau d'interconnexion électrique 20 (et également les lignes métalliques et les vias des autres niveaux d'interconnexion électrique 14). Une première possibilité consiste à réaliser la ligne métallique 21 à partir d'aluminium avantageusement inséré entre deux couches de titane ou de nitrure de titane, et à réaliser les vias 22 en tungstène. Une deuxième possibilité est de réaliser la ligne métallique 21 et les vias 22 en cuivre selon un procédé damascène comprenant le remplissage des tranchées formées dans la couche diélectrique 27, ou diélectrique inter-métal, avec du cuivre. Il peut s'agir d'un procédé simple damascène dans lequel on réalise en deux étapes damascènes successives les vias 22 puis la ligne métallique 21, ou bien d'un procédé double damascène tel que représenté sur la figure 1B, dans lequel les réalisations de la ligne métallique 21 et des vias 22 sont intégrées dans un processus « continu » de fabrication. Le coeur de ces éléments 21 et 22 est formé par des portions de cuivre 23 élaborées par électrolyse d'un sel cuivré en solution (dépôt ECD). Les faces inférieures et les faces latérales de ces portions de cuivre 23 sont en outre enrobées par un ensemble de couches conductrices, par exemple de nitrure de tantale 24, de tantale 25 et de cuivre 26, élaborées avantageusement par pulvérisation cathodique ionisante (également appelé iPVD) afin d'améliorer le recouvrement de ces dépôts sur les flancs verticaux. La couche de tantale 25 forme une couche barrière empêchant la diffusion du cuivre 23 et 26 dans le diélectrique inter-métal 27 et vers les couches de semi-conducteur 13 du circuit de lecture 12 où ce cuivre créerait sinon des défauts électriques notamment dans les transistors et les diodes. La couche de nitrure de tantale 24 est généralement prévue pour améliorer l'adhésion de la couche de tantale 25 à la surface du diélectrique inter-métal 27. La couche de cuivre 26 sert à la fois de cathode et de couche de germination pour la croissance électrolytique des portions de cuivre 23. L'affleurement du niveau d'interconnexion 20 à la surface du diélectrique inter-métal 27 est obtenu par un procédé de polissage mécano chimique (CMP) contrôlé par une couche d'arrêt 28 par exemple à base de SiO₂.

Une couche diélectrique isolante 29 recouvre la couche d'arrêt 28 et les faces supérieures des différentes portions de la ligne métallique 21. Cette couche 29 correspond ici à un bicouche formé par l'empilement d'une première couche disposée sur la couche d'arrêt 28 et d'une deuxième couche recouvrant cette première couche. La première couche de cet empilement est destinée à former une barrière de diffusion vis-à-vis du cuivre de la ligne métallique 21, et comporte par exemple du nitrure de silicium. La deuxième couche de l'empilement forme une couche d'arrêt de gravure apte à résister à une gravure HFv qui sera mise en oeuvre ultérieurement lors de la libération des membranes des bolomètres, qui protègera donc le niveau d'interconnexion électrique 20 lors de la libération des bolomètres. Cette deuxième couche de l'empilement comporte par exemple de l'Al₂O₃ ou de l'AIN.

Sur les figures suivantes, la ligne métallique 21 et les vias 22 sont représentés de manière moins détaillée que sur la figure 1B afin de faciliter la lecture de ces figures.

Une couche sacrificielle 30, comprenant au moins un matériau minéral tel que du SiO₂, est déposée sur la couche 29 (figure 1C). L'épaisseur (dimension selon l'axe Z) de la couche sacrificielle 30 est par exemple comprise entre environ 1 µm et 5 µm. L'épaisseur de la couche sacrificielle 30 est notamment choisie en fonction des propriétés d'absorption souhaitées vis-à-vis d'un rayonnement infrarouge destiné à être reçu et absorbé par les bolomètres du détecteur 100. Cette épaisseur est par exemple choisie afin que l'espace libéré par la gravure ultérieure de la couche sacrificielle 30 forme sous la membrane des bolomètres une cavité quart d'onde (notamment lorsque le détecteur 100 est destiné à réaliser une détection d'un rayonnement infrarouge dont la longueur d'onde appartient par exemple à la bande III (entre 8 à 12 µm)). L'épaisseur de la couche sacrificielle 30 peut être ajustée, après son dépôt, via la mise en oeuvre d'une planarisation de type CMP.

Comme représenté sur la figure 1D, une couche support 32 est ensuite déposée sur la couche sacrificielle 30. La couche support 32 peut comporter au moins un matériau sensible à la température, par exemple dont la résistivité varie sensiblement avec la température. Dans ce cas, la couche support 32 comporte par exemple du silicium amorphe déposé par CVD. En variante, la couche support 32 peut comporter au moins un matériau formant un isolant électrique ou doté d'une résistivité importante. Ainsi, outre le silicium amorphe, la couche support 32 peut comporter du SiC, de l'Al₂O₃, de l'AIN, etc. Dans tous les cas, le ou les matériaux de la couche support 32 sont inertes vis-à-vis de la gravure HFv qui sera mise en oeuvre ultérieurement lors de la gravure de la couche sacrificielle 30, c'est-à-dire aptes à résister (ne pas être gravés) à la ou aux solutions de gravure chimique utilisées pour graver la couche sacrificielle 30. Ainsi, le matériau de la couche sacrificielle 30 est apte à être gravé sélectivement vis-à-vis de la couche support 32 et de la première couche d'arrêt de gravure 29.

En outre, la couche support 32 peut correspondre à un empilement de plusieurs matériaux différents, par exemple un bicouche, tel que la couche inférieure de cet empilement (celle en contact avec la couche sacrificielle 30) protège la ou les autres couches supérieures de cet empilement lors de la gravure de la couche sacrificielle 30.

L'épaisseur de la couche support 32 est par exemple comprise entre environ 10 nm et 100 nm.

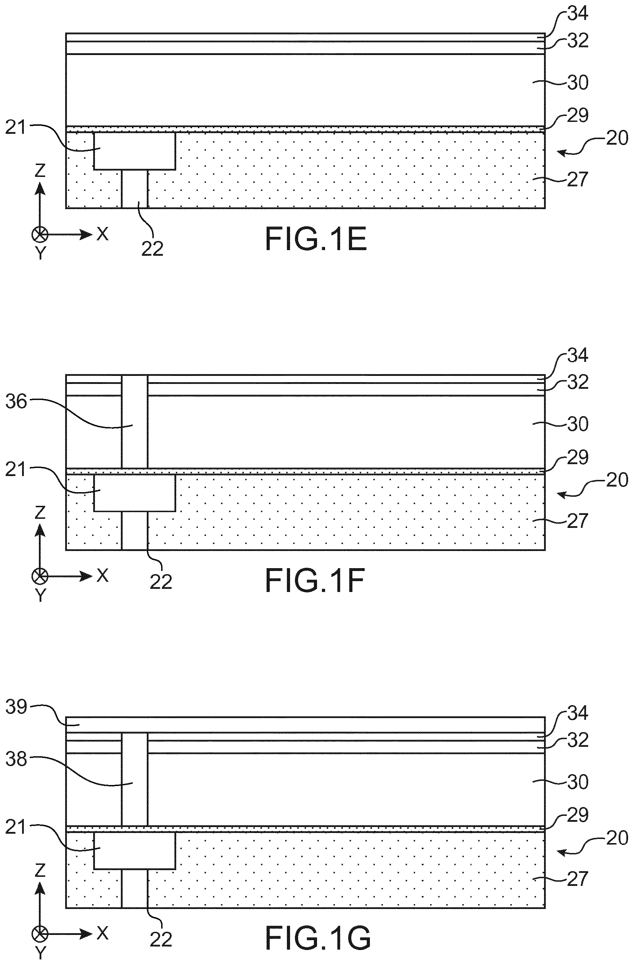

Une deuxième couche d'arrêt de gravure 34 est déposée ensuite sur la couche support 32 (figure 1E). Cette couche 34 est destinée à stopper un procédé d'ablation, ou de planarisation, qui sera mis en oeuvre ultérieurement pour supprimer un excès de matériau conducteur formé lors de la réalisation de vias électriquement conducteurs reliant les bolomètres à la ligne métallique 21, et cela afin de prévenir une dégradation de la couche 32 lors de cette suppression de matériau conducteur. La couche 34 comporte au moins un matériau résistant à l'abrasion mécanique et/ou chimique et/ou ionique qui sera mise en oeuvre, de préférence correspondant à au moins un matériau déjà utilisé lors de la réalisation des éléments se trouvant dans les couches de semi-conducteur 13, comme par exemple du SiN et/ou du SiO. La couche 34 a par exemple une épaisseur comprise entre environ 20 nm et 100 nm.

Des vias électriquement conducteurs 38 sont ensuite réalisés à travers l'empilement de couches précédemment formé sur le niveau d'interconnexion électrique 20. Sur les figures 1F à 1H, la réalisation d'un seul via électriquement conducteur 38 est décrite. Toutefois, plusieurs vias électriquement conducteurs sont réalisés à travers cet empilement. Le nombre de ces vias 38 dépend du nombre de bolomètres que le détecteur 100 est destiné à avoir. Ces vias électriquement conducteurs 38 sont destinés à assurer les liaisons électriques entre les bolomètres du détecteur 100 et le circuit de lecture 12, et également à assurer le maintien mécanique en suspension des membranes des bolomètres.

Comme représenté sur la figure 1F, une ouverture 36 est gravée à travers l'empilement formé des couches 34, 32, 30 et 29 précédemment réalisées. Cette ouverture 36 forme un accès à la ligne métallique 21 et est destiné à la réalisation d'un des vias électriquement conducteurs 38. La forme et les dimensions de la section de l'ouverture 36, dans un plan des couches 34, 32, 30 et 29 aux interfaces de ces couches traversées par cette ouverture 36, définissent la forme et les dimensions du via 38 qui sera réalisé dans cette ouverture 36, cette forme pouvant être par exemple circulaire ou polygonale, le diamètre ou une dimension d'un côté de cette ouverture pouvant être égal à environ 0,5 µm.

L'ouverture 36 est ensuite remplie d'un ou plusieurs matériaux électriquement conducteurs, formant ainsi le via électriquement conducteur 38. Une fine couche barrière, comprenant par exemple du TiN, est par exemple déposée contre les parois de l'ouverture 36 (au fond et contre les parois latérales), puis le volume vide restant dans l'ouverture 36 est rempli par un autre matériau électriquement conducteur, par exemple du tungstène déposé par CVD. La couche barrière présente au fond de l'ouverture 36, entre la ligne métallique 21 et l'autre matériau électriquement conducteur disposé dans l'ouverture 36, permet d'éviter une réaction chimique pouvant se produire entre le matériau électriquement conducteur (par exemple du cuivre) de la ligne métallique 21 et cet autre matériau électriquement conducteur (par exemple du tungstène) déposé dans l'ouverture 36. Cette couche barrière présente contre les parois latérales de l'ouverture 36 permet en outre d'améliorer l'adhérence dudit autre matériau électriquement conducteur déposé dans l'ouverture 36.

En variante, la métallisation du via électriquement conducteur 38 peut être réalisée en utilisant du cuivre. Les différents exemples de réalisation de la ligne métallique 21 et des vias 22 décrits précédemment peuvent s'appliquer pour la réalisation du via électriquement conducteur 38.

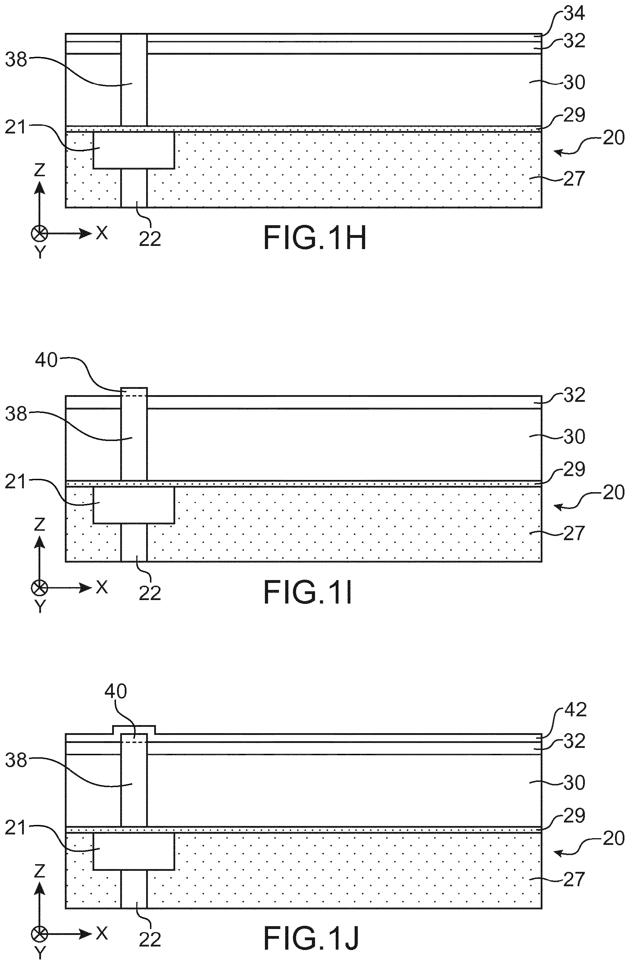

Après le dépôt du ou des matériaux électriquement conducteurs dans l'ouverture 36, une couche 39 de ce ou ces matériaux électriquement conducteurs déposés pour former le via électriquement conducteur 38 est présente sur la couche 34 (figure 1G). Une étape de retrait, par exemple par CMP, est mise en oeuvre afin de supprimer cette couche 39, la couche 34 servant de couche d'arrêt pour ce retrait (figure 1H).

La couche 34 est ensuite supprimée (figure 1I), par exemple par la mise en oeuvre d'une gravure chimique en milieu aqueux offrant une très bonne sélectivité de gravure vis-à-vis de la couche support 32 sous-jacente à la couche 34 et vis-à-vis du ou des matériaux électriquement conducteurs du via électriquement conducteur 38. Une telle gravure fait appel par exemple à une solution de gravure de type BOE (« Buffered Oxide Etch », ou oxyde gravant tamponné) ayant une base de HF dilué. Les agents de gravure sont choisis tels que la couche support 32 ne soit pas gravée par ces agents de gravure qui peuvent être de même nature que ceux qui seront utilisés ultérieurement pour graver la couche sacrificielle 30. Cette gravure de la couche 34 révèle une partie supérieure 40 du via électriquement conducteur 38 (délimitée symboliquement du reste du via 38 par un trait pointillé) dont les flancs latéraux ne sont recouverts, à ce stade du procédé par aucun matériau. L'épaisseur de cette partie supérieure 40 est égale à celle de la couche 34.

Une couche électriquement conductrice 42 est ensuite déposée sur la couche support 32 et en recouvrant également la partie supérieure 40 du via électriquement conducteur 38, et notamment la face supérieure et les faces latérales de cette partie supérieure 40 du via électriquement conducteur 38 (figure 1J). La couche 42 comporte par exemple du TiN. Ce recouvrement de la partie supérieure 40 du via électriquement conducteur 38 par la couche 42 augmente la surface de contact entre le matériau conducteur de la couche 42 et le ou les matériaux conducteurs du via 38, et améliore ainsi la conduction électrique entre le pilier formé par le via 38 et la couche 42. Lorsque la membrane du bolomètre réalisé sera libérée en gravant la couche sacrificielle 30, le fait que la couche support 32 entoure le via 38 à un niveau se trouvant sous cette partie supérieure 40 du via 38 augmentera la robustesse mécanique de l'ensemble.

Le bolomètre est ensuite achevé en réalisant les différents éléments de transduction optique-thermique et thermique-électrique sur la couche support 32, en gravant la couche support 32 (et d'éventuelles autres couches déposées sur la couche support 32) pour former la membrane du bolomètre, et en gravant la couche sacrificielle 30 afin de libérer cette membrane.

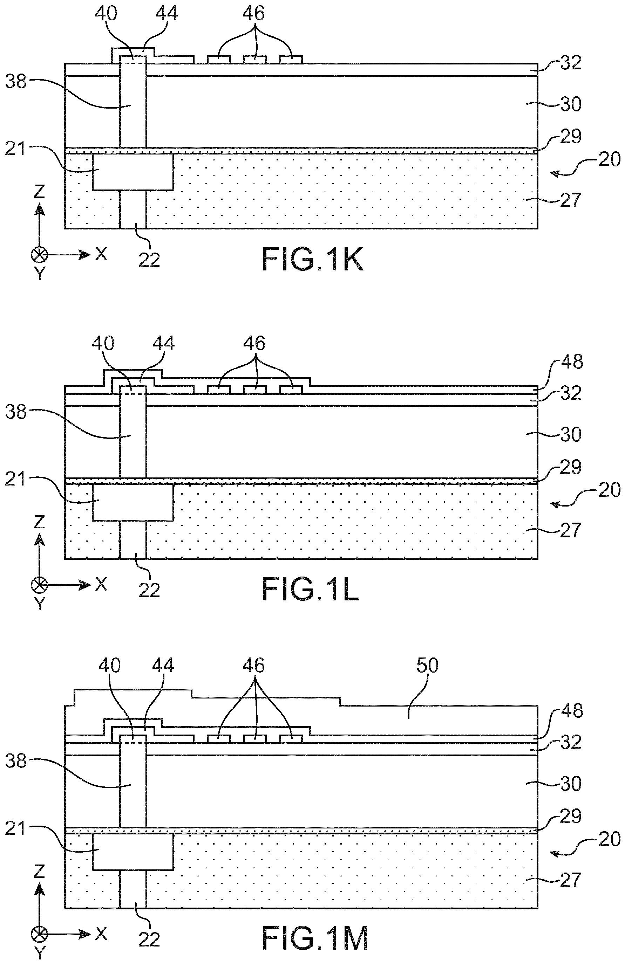

Dans le premier mode de réalisation décrit ici, la couche 42 est gravée telle que des portions restantes de cette couche forme des électrodes 44 du bolomètre directement en contact avec le ou les matériaux conducteurs des vias 38 (une seule électrode 44 est représentée sur la figure 1K). D'autres portions restantes de la couche 42 forment des portions résistives 46 aptes à absorber le rayonnement infrarouge destiné à être détecté par le détecteur 100. Les portions de la couche support 32 en silicium amorphe qui ne sont pas recouvertes par les électrodes 44 et les portions résistives 46 formeront des régions de transduction thermique-électrique du bolomètre. Les électrodes 44 et les portions résistives 46 peuvent être de différentes formes. A titre d'exemple, les portions résistives 46 peuvent correspondre à deux parties de la couche 42 espacées l'une de l'autre par une fente gravée à travers la couche 42 de telle façon que le courant ne puisse pas passer entre ces portions 46. D'autres formes et/ou un nombre différent de portions résistives 46 sont envisageables.

Comme représenté sur la figure 1L, une couche de transduction thermique-électrique 48, appelée première couche de transduction thermique-électrique, est déposée sur les portions restantes 44, 46 de la couche 42 et sur les parties de la couche support 32 non recouvertes par ces portions 44, 46. Cette couche 48, comprenant par exemple du silicium amorphe, est destinée à assurer, avec la couche support 32 (car celle-ci est également en silicium amorphe dans ce premier mode de réalisation), la conversion en énergie électrique du rayonnement infrarouge qui sera reçu par le bolomètre. De plus, les couches 32 et 48 permettent de compenser un effet bilame se produisant entre les portions 46 de la couche électriquement conductrice et la couche support 32.

Une deuxième couche de transduction thermique-électrique 50 est déposée ensuite sur la couche 48 (figure 1M). De manière avantageuse, cette couche 50 comporte du silicium amorphe et a une épaisseur supérieure à celle de la couche 48 et à celle de la couche support 32.

Cette deuxième couche 50 est gravée afin qu'au moins une partie restante 52 de cette couche 50 soit apte à former au moins un élément de transduction thermique-électrique du bolomètre. Dans le premier mode de réalisation décrit ici, la partie restante 52 forme un élément thermométrique centrale de la membrane 54. De manière avantageuse, les parties de la deuxième couche 50 localisées sur les zones destinées à former les bras de maintien de la membrane 54 sont supprimées lors de cette gravure, ce qui permet de doter la membrane 54 d'une isolation thermique élevée. Le procédé de gravure de la deuxième couche 50 peut avantageusement avoir recours à une couche d'arrêt de gravure, ce qui permet notamment de bien contrôler l'épaisseur dans les bras de maintien.

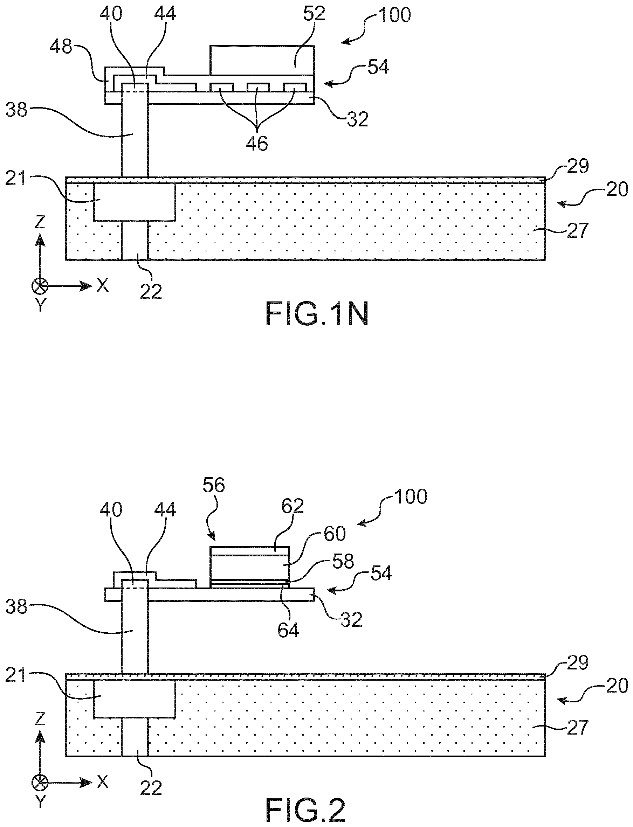

Les couches 48 et 32 sont ensuite gravées selon le motif souhaité pour former la membrane 54 du bolomètre et les bras de maintien de la membrane 54. Enfin, la couche sacrificielle 30 est gravée chimiquement et sélectivement vis-à-vis des matériaux des couches 32, 48, 50 et 29, libérant ainsi la membrane 54 qui est suspendue grâce aux vias 38 (figure 1N).

Le détecteur thermique infrarouge 100 obtenu est formé d'un élément central comportant, outre les éléments absorbeurs 46 réalisés par exemple sous la forme de rubans métalliques, d'éléments thermométriques correspondant aux portions superposées de matériaux sensibles à la température issues des trois couches 32, 48, 52 dont l'épaisseur totale est sensiblement supérieure à la somme des épaisseurs des couches 32 et 48. Dans ce cas, il s'ensuit une diminution du bruit électrique des éléments thermométriques selon une loi inversement proportionnelle à l'épaisseur des éléments thermométriques. Cet élément central est relié électriquement et mécaniquement aux vias électriquement conducteurs 38 par l'intermédiaire de bras formés par la superposition des matériaux des couches 32, 42 et 48, l'épaisseur de ces bras étant sensiblement inférieure à celle de l'élément central. Il s'ensuit une diminution de la conductance thermique de ces bras et par voie de conséquence une meilleure isolation thermique de l'élément central et un gain de sensibilité du détecteur 100.

A l'issu du procédé, le ou les bolomètres réalisés sont placés dans une enceinte hermétique.

Selon un deuxième mode de réalisation, la couche support 32 peut servir à former l'élément thermométrique du bolomètre du détecteur 100, et l'élément absorbeur du détecteur peut être formé par une ou plusieurs structures MIM (Métal - Isolant - Métal) réalisées sur la membrane du bolomètre. La figure 2 représente un détecteur 100 obtenu en mettant en oeuvre un procédé selon ce deuxième mode de réalisation, la référence 56 désignant une structure MIM qui est formée d'une portion métallique inférieure 58, d'une portion diélectrique 60 et d'une portion métallique supérieure 62. Une portion diélectrique 64, comprenant un matériau diélectrique apte à résister à la gravure HF finale tel que par exemple de l'AIN ou de l'Al₂O₃, est disposée entre la portion métallique inférieure 58 et la couche 32 afin d'isoler électriquement l'élément thermométrique formé par la couche 32 vis-à-vis de la portion métallique inférieure 58. Cette portion diélectrique 64 est parexemple réalisée en déposant une couche du matériau de cette portion 64 préalablement aux dépôts des matériaux de la structure MIM 56, et gravée en même temps que les matériaux formant la structure MIM 56. Dans ce deuxième mode de réalisation, la structure MIM 56 est formée directement sur la couche 32 gravée formant la membrane du bolomètre. Ici, la partie de la couche 32 formant la membrane assure la transduction thermique - électrique au sein du bolomètre. La structure MIM 56 permet notamment de réaliser une absorption sélective des longueurs d'onde.

Comme dans le premier mode de réalisation, la liaison électrique entre le matériau conducteur présent dans la membrane du bolomètre et le circuit de lecture du détecteur est assurée grâce aux électrodes 44 qui recouvrent directement les vias électriquement conducteurs 38.

De manière générale, la mise en oeuvre des étapes précédemment décrites en lien avec les figures 1A à 1J permet de former une base pour recevoir les différents éléments des bolomètres, c'est-à-dire les éléments réalisant les transductions optique - thermique et thermique - électrique au sein du bolomètre. Les différentes configurations de ces éléments décrites dans le document EP 2 743 659 A1 peuvent s'appliquer pour former le détecteur 100.

Le procédé de réalisation décrit ci-dessus peut s'appliquer pour la réalisation d'un détecteur 100 comportant un seul bolomètre ou plusieurs bolomètres.

## Revendications

1. Procédé de réalisation d'un détecteur (100) bolométrique comprenant au moins la mise en oeuvre les étapes suivantes :
- réalisation d'un empilement de couches (29, 30, 32, 34) sur un niveau d'interconnexion électrique (20) d'un circuit électronique de lecture (12) du détecteur (100), l'empilement comprenant au moins une couche sacrificielle (30) disposée entre une couche support (32) et une première couche d'arrêt de gravure (29), la première couche d'arrêt de gravure (29) étant disposée entre la couche sacrificielle (30) et ledit niveau d'interconnexion électrique (20), et la couche sacrificielle (30) comprenant au moins un matériau minéral apte à être gravé sélectivement vis-à-vis de la couche support (32) et de la première couche d'arrêt de gravure (29) ;
- réalisation d'au moins un via (38) électriquement conducteur traversant au moins l'empilement de couches (29, 30, 32, 34) tel qu'au moins un matériau électriquement conducteur du via (38) soit en contact avec au moins une portion électriquement conductrice (21) dudit niveau d'interconnexion électrique (20) reliée au circuit électronique de lecture (12) ;
- dépôt d'au moins une couche électriquement conductrice (42) sur la couche support (32) et le via (38) ;
- gravure de la couche électriquement conductrice (42) et de la couche support (32), formant une membrane (54) de bolomètre reliée électriquement au via (38) par au moins une portion restante (44) de la couche électriquement conductrice (42) qui recouvre au moins une partie supérieure (40) du via (38) ;
- suppression de la couche sacrificielle (30) par une gravure chimique à laquelle la première couche d'arrêt de gravure (29) et la couche support (32) résistent, et telle que la membrane (54) soit suspendue par l'intermédiaire du via (38) ;
dans lequel l'empilement de couches (29, 30, 32, 34) comporte en outre une deuxième couche d'arrêt de gravure (34) telle que la couche support (32) soit disposée entre la deuxième couche d'arrêt de gravure (34) et la couche sacrificielle (30), le procédé comportant en outre, entre la réalisation du via (38) et le dépôt de la couche électriquement conductrice (42), la mise en oeuvre des étapes suivantes :
- retrait d'une couche de matériau électriquement conducteur (39) formée sur la deuxième couche d'arrêt de gravure (34) lors de la réalisation du via (38), puis
- suppression de la deuxième couche d'arrêt de gravure (34),
et dans lequel la couche électriquement conductrice (42) est déposée telle que la portion restante (44) de la couche électriquement conductrice (42) recouvre également des flancs latéraux de la partie supérieure (40) du via (38) découverts par la suppression de la deuxième couche d'arrêt de gravure (34).

2. Procédé selon la revendication 1, dans lequel la couche support (32) comporte au moins un matériau diélectrique ou un matériau dont au moins un paramètre électrique varie en fonction de sa température.

3. Procédé selon l'une des revendications précédentes, comportant en outre, avant la suppression de la couche sacrificielle (30), la réalisation d'au moins un élément (56) absorbeur de rayonnement infrarouge destiné à être détecté par le détecteur (100), sur la membrane (54).

4. Procédé selon la revendication 3, dans lequel l'élément absorbeur comporte au moins une structure MIM (56).

5. Procédé selon l'une des revendications précédentes, dans lequel la couche électriquement conductrice (42) est gravée telle qu'une pluralité de portions restantes de ladite couche électriquement conductrice (42) forment des électrodes (44) de bolomètre et des portions résistives (46) aptes à absorber un rayonnement infrarouge destiné à être détecté par le détecteur (100).

6. Procédé selon l'une des revendications précédentes, comportant en outre, entre la gravure de la couche électriquement conductrice (42) et la gravure de la couche support (32), le dépôt d'une première couche (48) de transduction thermique-électrique sur les portions restantes (44, 46) de la couche électriquement conductrice (42) et sur la couche support (32).

7. Procédé selon la revendication 6, dans lequel la première couche (48) de transduction thermique-électrique comporte au moins un matériau résistant à la gravure chimique mise en oeuvre pour supprimer la couche sacrificielle (30).

8. Procédé selon l'une des revendications 6 ou 7, comportant en outre, après le dépôt de la première couche (48) de transduction thermique-électrique, le dépôt d'une deuxième couche (50) de transduction thermique-électrique sur la première couche (48) de transduction thermique-électrique et dont l'épaisseur est supérieure à celle de la première couche (48) de transduction thermique-électrique.

9. Procédé selon l'une des revendications précédentes, dans lequel :
- la couche support (32) comporte du silicium amorphe, et/ou
- lorsqu'une première couche (48) de transduction thermique-électrique est déposée, la première couche (48) de transduction thermique-électrique comporte du silicium amorphe, et/ou
- lorsqu'une deuxième couche (50) de transduction thermique-électrique est déposée, la deuxième couche (50) de transduction thermique-électrique comporte du silicium amorphe.

## Patentansprüche

1. Verfahren zum Herstellen eines bolometrischen Detektors (100), welches mindestens das Umsetzen der folgenden Schritte umfasst:
- Herstellen einer Stapelung von Schichten (29, 30, 32, 34) auf einer elektrischen Verbindungsebene (20) einer elektronischen Leseschaltung (12) des Detektors (100), wobei die Stapelung mindestens eine Opferschicht (30) umfasst, die zwischen einer Trägerschicht (32) und einer ersten Ätzstoppschicht (29) angeordnet ist, wobei die erste Ätzstoppschicht (29) zwischen der Opferschicht (30) und der elektrischen Verbindungsebene (20) angeordnet ist, und die Opferschicht (30) mindestens einen mineralischen Werkstoff umfasst, der imstande ist, selektiv gegenüber der Trägerschicht (32) und der ersten Ätzstoppschicht (29) geätzt zu werden;
- Herstellen mindestens einer elektrisch leitfähigen Durchkontaktierung (38), die mindestens die Stapelung von Schichten (29, 30, 32, 34) durchquert, sodass mindestens ein elektrisch leitfähiger Werkstoff der Durchkontaktierung (38) in Kontakt mit mindestens einem elektrisch leitfähigen Abschnitt (21) der elektrischen Verbindungsebene (20) ist, der mit der elektronischen Leseschaltung (12) verbunden ist;
- Abscheiden mindestens einer elektrisch leitfähigen Schicht (42) auf der Trägerschicht (32) und der Durchkontaktierung (38);
- Ätzen der elektrisch leitfähigen Schicht (42) und der Trägerschicht (32), wodurch eine Bolometer-Membran (54) gebildet wird, die durch mindestens einen verbleibenden Abschnitt (44) der elektrisch leitfähigen Schicht (42), welche mindestens einen oberen Teil (40) der Durchkontaktierung (38) abdeckt, elektrisch mit der Durchkontaktierung (38) verbunden ist;
- Entfernen der Opferschicht (30) durch chemisches Ätzen, welchem die erste Ätzstoppschicht (29) und die Trägerschicht (32) standhalten, und sodass die Membran (54) anhand der Durchkontaktierung (38) aufgehängt ist;
wobei die Stapelung von Schichten (29, 30, 32, 34) weiter eine zweite Ätzstoppschicht (34) beinhaltet, sodass die Trägerschicht (32) zwischen der zweiten Ätzstoppschicht (34) und der Opferschicht (30) angeordnet ist,
wobei das Verfahren weiter zwischen dem Herstellen der Durchkontaktierung (38) und dem Abscheiden der elektrisch leitfähigen Schicht (42) das Umsetzen der folgenden Schritte beinhaltet:
- Abtragen einer Schicht aus elektrisch leitfähigem Werkstoff (39), die beim Herstellen der Durchkontaktierung (38) auf der zweiten Ätzstoppschicht (34) gebildet wird, danach
- Entfernen der zweiten Ätzstoppschicht (34),
und wobei die elektrisch leitfähige Schicht (42) abgeschieden wird, sodass der verbleibende Abschnitt (44) der elektrisch leitfähigen Schicht (42) auch seitliche Flanken des oberen Teils (40) der Durchkontaktierung (38) abdeckt, die durch das Entfernen der zweiten Ätzstoppschicht (34) freigelegt sind.

2. Verfahren nach Anspruch 1, wobei die Trägerschicht (32) mindestens einen dielektrischen Werkstoff oder einen Werkstoff beinhaltet, von dem mindestens ein elektrischer Parameter in Abhängigkeit von seiner Temperatur variiert.

3. Verfahren nach einem der vorstehenden Ansprüche, welches weiter vor dem Entfernen der Opferschicht (30) das Herstellen mindestens eines Absorptionselements (56) für Infrarotstrahlung, das dazu bestimmt ist, durch den Detektor (100) detektiert zu werden, auf der Membran (54) beinhaltet.

4. Verfahren nach Anspruch 3, wobei das Absorptionselement mindestens eine MIM-Struktur (56) beinhaltet.

5. Verfahren nach einem der vorstehenden Ansprüche, wobei die elektrisch leitfähige Schicht (42) geätzt wird, sodass eine Vielzahl von verbleibenden Abschnitten der elektrisch leitfähigen Schicht (42) Bolometer-Elektroden (44) und Widerstandsabschnitte (46) bilden, die imstande sind, eine Infrarotstrahlung, die dazu bestimmt ist, von dem Detektor (100) detektiert zu werden, zu absorbieren.

6. Verfahren nach einem der vorstehenden Ansprüche, welches weiter zwischen dem Ätzen der elektrisch leitfähigen Schicht (42) und dem Ätzen der Trägerschicht (32) das Abscheiden einer ersten Schicht (48) zur thermisch-elektrischen Transduktion auf den verbleibenden Abschnitten (44, 46) der elektrisch leitfähigen Schicht (42) und auf der Trägerschicht (32) beinhaltet.

7. Verfahren nach Anspruch 6, wobei die erste Schicht (48) zur thermisch-elektrischen Transduktion mindestens einen Werkstoff beinhaltet, welcher dem chemischen Ätzen standhält, das angewendet wird, um die Opferschicht (30) zu entfernen.

8. Verfahren nach einem der Ansprüche 6 oder 7, welches weiter nach dem Abscheiden der ersten Schicht (48) zur thermisch-elektrischen Transduktion das Abscheiden einer zweiten Schicht (50) zur thermisch-elektrischen Transduktion auf der ersten Schicht (48) zur thermisch-elektrischen Transduktion beinhaltet, und deren Dicke größer als jene der ersten Schicht (48) zur thermisch-elektrischen Transduktion ist.

9. Verfahren nach einem der vorstehenden Ansprüche, wobei:
- die Trägerschicht (32) amorphes Silicium beinhaltet, und/oder
- wenn eine erste Schicht (48) zur thermisch-elektrischen Transduktion abgeschieden wird, die erste Schicht (48) zur thermisch-elektrischen Transduktion amorphes Silicium beinhaltet, und/oder
- wenn eine zweite Schicht (50) zur thermisch-elektrischen Transduktion abgeschieden wird, die zweite Schicht (50) zur thermisch-elektrischen Transduktion amorphes Silicium beinhaltet.

## Claims

1. A method for making a bolometric detector (100) comprising at least the implementation of the following steps of:
- making a stack of layers (29, 30, 32, 34) over an electrical interconnect level (20) of an electronic read-out circuit (12) of the detector (100), the stack comprising at least one sacrificial layer (30) arranged between a support layer (32) and a first etch stop layer (29), the first etch stop layer (29) being arranged between the sacrificial layer (30) and said electrical interconnect level (20), and the sacrificial layer (30) comprising at least one mineral material capable of being etched selectively with respect to the support layer (32) and the first etch stop layer (29);
- making at least one electrically-conductive via (38) crossing at least the stack of layers (29, 30, 32, 34) such that at least one electrically-conductive material of the via (38) is in contact with at least one electrically-conductive portion (21) of said electrical interconnect level (20) connected to the electronic read-out circuit (12);
- depositing at least one electrically-conductive layer (42) over the support layer (32) and the via (38);
- etching the electrically-conductive layer (42) and the support layer (32), forming a bolometer membrane (54) electrically connected to the via (38) by at least one remaining portion (44) of the electrically-conductive layer (42) that covers at least one upper portion (40) of the via (38);
- eliminating the sacrificial layer (30) by chemical etching to which the first etch stop layer (29) and the support layer (32) are resistant, and such that the membrane (54) is suspended by means of the via (38);
wherein the stack of layers (29, 30, 32, 34) further includes a second etch stop layer (34) such that the support layer (32) is arranged between the second etch stop layer (34) and the sacrificial layer (30),
the method further including, between making the via (38) and depositing the electrically-conductive layer (42), the implementation of the following steps of:
- removing an electrically-conductive material layer (39) formed over the second etch stop layer (34) during making of the via (38), then
- eliminating the second etch stop layer (34),
and wherein the electrically-conductive layer (42) is deposited such that the remaining portion (44) of the electrically-conductive layer (42) also covers lateral sidewalls of the upper portion (40) of the via (38) uncovered by the elimination of the second etch stop layer (34).

2. The method according to claim 1, wherein the support layer (32) includes at least one dielectric material or a material at least one electric parameter of which varies according to its temperature.

3. The method according to one of the preceding claims, further including, before eliminating the sacrificial layer (30), making at least one element (56) for absorbing the infrared radiation intended to be detected by the detector (100), on the membrane (54).

4. The method according to claim 3, wherein the absorbing element includes at least one MIM structure (56).

5. The method according to one of the preceding claims, wherein the electrically-conductive layer (42) is etched such that a plurality of remaining portions of said electrically-conductive layer (42) form bolometer electrodes (44) and resistive portions (46) capable of absorbing an infrared radiation intended to be detected by the detector (100).

6. The method according to one of the preceding claims, further including, between etching the electrically-conductive layer (42) and etching the support layer (32), depositing a first thermoelectric transduction layer (48) over the remaining portions (44, 46) of the electrically-conductive layer (42) and over the support layer (32).

7. The method according to claim 6, wherein the first thermoelectric transduction layer (48) includes at least one material that is resistant to the chemical etching process implemented to eliminate the sacrificial layer (30).

8. The method according to one of claims 6 or 7, further including, after depositing the first thermoelectric transduction layer (48), depositing a second thermoelectric transduction layer (50) over the first thermoelectric transduction layer (48) and whose thickness is larger than that of the first thermoelectric transduction layer (48).

9. The method according to one of the preceding claims, wherein:
- the support layer (32) includes amorphous silicon, and/or
- in the case where a first thermoelectric transduction layer (48) is deposited, the first thermoelectric transduction layer (48) includes amorphous silicon, and/or
- in the case where a second thermoelectric transduction layer (50) is deposited, the second thermoelectric transduction layer (50) includes amorphous silicon.
